Europäisches Patentamt

European Patent Office

Office européen des brevets

(11) Publication number: **0 127 857**
**B1**

# (12) EUROPEAN PATENT SPECIFICATION

(45) Date of publication of patent specification: 29.07.87

(21) Application number: **84105991.8**

(22) Date of filing: **25.05.84**

(51) Int. Cl.⁴: **C 25 D 5/12,** C 25 D 3/46, C 25 D 3/48, C 25 D 3/50, C 25 D 5/36, H 01 L 23/50

(54) Solderable stainless steel article and method for making same.

(30) Priority: 28.05.83 JP 93385/83
28.05.83 JP 93386/83

(43) Date of publication of application:
12.12.84 Bulletin 84/50

(45) Publication of the grant of the patent:
29.07.87 Bulletin 87/31

(84) Designated Contracting States:
DE FR GB IT

(56) References cited:
EP-A-0 067 567
EP-A-0 075 784
DE-A-3 139 815
DE-B-1 285 068
GB-A-1 017 196

(73) Proprietor: Kobayashi, Masami
3-13-15, Hachimanyama Setagaya-ku
Tokyo (JP)

(72) Inventor: Kobayashi, Masami
3-13-15, Hachimanyama Setagaya-ku
Tokyo (JP)

(74) Representative: Görtz, Dr. Fuchs, Dr.
Luderschmidt Patentanwälte
Sonnenberger Strasse 100 Postfach 26 26
D-6200 Wiesbaden (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

## Background of the invention

### (1) Field of the invention

This invention relates to a solderable stainless steel article and method for making the same.

### (2) Description of the prior art

Soldering of stainless steel is difficult because of the presence of a tight passive coating on the surface thereof, and direct soldering of stainless steel has been considered impossible. This passive coating is a coating inherent to stainless steel, and the name "stainless steel" is given because of the presence of this coating and stainless steel is widely used as a rust-resisting material. It is said that this coating is formed by incorporation of Cr, namely, if at least about 13% of chrominum is present in iron, a passive coating is formed.

If a passive coating on the surface of stainless steel is removed by hydrofluoric acid or a mixed acid of hydrofluoric acid and nitric and soldering is immediately performed, soldering is barely possible, but the soldered portion or the vicinity thereof is corroded by residual hydrofluoric acid and hence, water washing should be performed after soldering and this method is poor in the practical utility.

As means for preparing a stainless steel band having a solderability, there has been proposed a method in which the surface of stainless steel is preliminarily treated with a mixed acid of hydrofluoric acid and nitric acid, copper plating is effected on the pre-treated surface, tin or solder plating is then effected on the surface and a skin pass treatment is carried out to smoothen the surface. This method, however, is defective in that the steps are complicated, the manufacturing cost is great, and an oxide is formed on the finished surface with the lapse of time and this oxide degrades the solderability.

As means for imparting solderability and wire bondability to stainless steel, there has been tried a method in which nickel plating is effected on the surface. However, an oxide is formed on the nickel surface with the lapse of time, and soldering is difficult unless an acid treatment is carried out in advance. Moreover, the surface condition does not allow soldering.

Stainless steel has excellent corrosion resistance and spring property, and it is widely used in various fields by dint of these excellent characteristics. However, since soldering of stainless steel is difficult, uses of stainless steel are considerably limited. For example, stainless steel has excellent corrosion resistance and spring property as mentioned above and is rich in the creep characteristics to high and low temperatures, and it has properties suitable for a lead frame, a kind of an electronic part. However, since stainless steel is poor in the solderability and wire bondability, stainless steel has not been utilized for a lead frame.

## Summary of the invention

It is therefore a primary object of the present invention to provide a stainless steel article which can be soldered easily and tightly.

More specifically, in accordance with the present invention, there is provided a stainless steel article having a solderability, which comprises a thin plating layer of nickel formed on the surface of stainless steel and an ultra-thin plating layer of a metal selected from gold, silver and palladium or an alloy selected from alloys of gold, silver and palladium, which is formed on the nickel plating layer, wherein the amount of the deposited nickel is so small that a color tone intermediate between the color tone of stainless steel and the color tone of nickel is produced when plated with nickel, and the amount of the deposited gold, silver, palladium or alloy thereof is so small that a color tone intermediate between the color tone of the nickelplated stainless steel and the color tone of the gold, silver, palladium or alloy thereof used, when plated with these metals.

## Detailed description of the preferred embodiments

According to the present invention, there is provided a solderable stainless steel article, in which the amount of the plated metal deposited is very small, the plating cost is smaller than that of solder plating for which thick plating is recommended, though a noble metal is used in the present invention, and when gold is used, no change with the lapse of time is caused because of excellent corrosion resistance of gold and no surface oxide is formed, resulting in increase of the reliability to the soldering operation.

In the present invention, prior to thin plating of nickel, only a passive coating is removed by alkali degreasing and activating treatments of the surface of stainless steel. The alkali degreasing treatment may be carried out according to the conventional method using a commercially available alkali degreasing solution. According to one preferred embodiment, stainless steel is dipped in a dilute solution of an alkali degreasing solution at an elevated temperature and electrolytic degreasing is then carried out in a dilute aqueous alkali solution.

After the alkali degreasing treatment, the stainless steel article is subjected to the activating treatment. It is preferred that this activating treatment be carried out in two stages. Namely, the activating treatment comprises the first step of dipping in an activating solution and the subsequent step of cathodic electrolysis in a cathodic electrolytic solution. This activating treatment will now be described.

The activating solution used in the first activating treatment is preferably an aqueous mixed acid solution containing, based on the weight of the solution:

    (i) 3 to 20% by weight of hydrochloric acid,
    (ii) 2 to 30% by weight of sulfuric acid,
    (iii) 0.1 to 5% by weight of a nonionic or cationic surface active agent and

(iv) 0.1 to 20% by weight of 2-pyrrolidone or its N-alkyl derivative.

More preferably, the activating solution is an aqueous mixed acid solution containing, based on the weight of the solution:

(i) 3 to 10% by weight of hydrochloric acid,

(ii) 0.5 to 4% by weight of nitric acid,

(iii) 2 to 15% by weight of sulfuric acid,

(iv) 1 to 5% by weight of acetic acid,

(v) 3 to 10% by weight of citric acid,

(vi) 0.1 to 3% by weight of an nonionic or cationic surface active agent,

(vii) 0.1 to 10% by weight of 2-pyrrolidone or its N-alkyl derivative and

(viii) 1 to 5% by weight of an acetylenic glycol.

If the amount of hydrochloric acid and sulfuric acid are too small, no substantial activating effect can be obtained, and if the amount of these acids are too large, over-pickling occurs.

If the amount of the nonionic or cationic surface active agent is smaller than 0.1% by weight, it is impossible to reduce the surface tension of the activating solution to the desired value, i.e., 30 dyne/cm or lower, and this surfactant need not be incorporated in a amount exceeding 5% by weight. The nonionic surface active agent used includes, for example, polyoxyethylene alkyl ethers such as polyoxyethylene lauryl ether. The cationic surface active agent includes, for example, perfluoroalkyl trimethylammonium salts. Among these surface active agents, nonionic surface active agents are preferable.

It is considered that 2-pyrrolidone or its N-alkyl derivative exerts a function of assuredly removing the passive state film and surface oxide dissolved in the mixed acid by virtue of excellent dissolving and washing powers thereof. It also exerts a function of assisting the acetylenic glycol's effect of preventing surface clouding. As the N-alkyl derivative of 2-pyrrolidone, those which have an alkyl group of 1 to 5 carbon atoms, are used. Preferable N-alkyl derivatives are N-ethyl-2-pyrrolidone and N-methyl-2-pyrrolidone.

The first activation treatment may be carried out by dipping the stainless steel in the activating solution at a normal temperature for 30 seconds to 7 minutes.

The activated stainless steels are then subjected to cathode electrolytic activation. The cathode electrolytic activation solution used in this step is preferably an aqueous mixed acid solution containing, based on the weight of the solution:

(i) 5 to 20% by weight of phosphoric acid,

(ii) 2 to 10% by weight of nitric acid,

(iii) 0.1 to 5% by weight of a nonionic surface active agent and

(iv) 0.1 to 20% by weight of 2-pyrrolidone or its N-alkyl derivative.

More preferably, the solution used in the cathode electrolytic activation step is an aqueous mixed acid solution containing, based on the weight of the solution:

(i) 5 to 10% by weight of phosphoric acid,

(ii) 2 to 10% by weight of citric acid,

(iii) 1 to 5% by weight of oxalic acid,

(iv) 2 to 5% by weight of nitric acid,

(v) 3 to 20%, especially 3 to 10%, by weight of sulfuric acid,

(vi) 0.1 to 3% by weight of a nonionic or cationic surface active agent,

(vii) 0.5 to 10%, especially 0.5 to 5%, by weight of gluconic acid,

(viii) 0.1 to 10% by weight of 2-pyrrolidone or its N-alkyl derivative and

(ix) 1 to 5% by weight of an acetylenic glycol.

If the amount of phosphoric acid is smaller than 5% by weight, no substantial cathode electrolytic activating effect can be attained, and if the amount of phosphoric acid exceed 20% by weight, no substantial increase of the effect can be obtained, If the amount of nitric acid is smaller than 2% by weight, the cathode electrolytic activating effect is low, and if nitric acid is incorporated in an amount exceeding 10% by volume, a passive state film is formed on the surface of a stainless steel and there arises a risk of plating failure.

When the amount of the nonionic or cationic surface active agent is smaller than 0.1% by weight, it is impossible to reduce the surface tension of the cathode electrolytic activating solution to the desired value, i.e., 30 dyne/cm or lower, and it is not necessary to use the surfactant in an amount exceeding 5% by weight. The nonionic surface active agents and the cationic surface active agents used include those which are hereinbefore mentioned with respect to the activating solution used in the first activating step. In general, the nonionic surface active agents are more preferable than the cationic surface active agents.

If the mount of 2-pyrrolidone or its N-alkyl derivative is smaller than 0.1% by weight, the washing effect and the effect of preventing clouding by an acetylenic glycol cannot be attained, and if the amount of 2-pyrrolidone or its N-alkyl derivative is larger than 20% by weight, a large quantity of heat is generated at the time of incorporation and 2-pyrrolidone or its N-alkyl derivative is wastefully consumed. As the N-alkyl derivative of 2-pyrrolidone, those which have an alkyl group of 1 to 5 carbone atoms, are used. Preferable N-alkyl derivatives are N-ethyl-2-pyrrolidone and N-methyl-2-pyrrolidone.

At the cathode electrolytic activation step, electrolysis may be carried out at a normal temperature at a cathode current density of 1 to 7 A/dm² for 30 seconds to 5 minutes by using a platinum-coated titanium anode and the stainless steel as the cathode.

The stainless steel article which has been subjected to the activating treatment is then subejcted to nickel plating. This nickel plating is performed according to the conventional electrolytic plating method using nickel salts such as nickel sulfate, nickel sulfamate and nickel chloride.

The nickel electroplating may be carried out at a temperature of 45° to 65°C in an electroplating solution at a cathode current density of 4 to 12 A/

dm$^2$ for 10 seconds to 2 minutes by using the stainless steel as the cathode and a nickel plate as the anode.

In the present invention, the amount of the nickel deposited is important. Namely, the amount of the nickel is so small that a color tone intermediate between the color tone before plating and the color tone of nickel is produced on the surface. Supposing that a uniform film of nickel is formed by plating (actually, no uniform film is formed because the amount of the nickel deposited is vary small), the amount of nickel is ordinarily controlled so that a film having a thickness of 100 to 1,000Å, preferably 300 to 700Å, most preferably about 500Å, is formed.

The nickel-plated stainless steel is immediately electroplated with gold, silver or palladium or an alloy thereof. The electroplating procedure may be conventional. Usually, the electroplating is carried out at a temperature of 40° to 65°C at a cathode current density of 0.5 to 18 A/dm$^2$ for one second to two minutes by using the stainless steel as the cathode and a nickel plate as the anode. The electroplating of gold may be carried out preferably by using an electroplating solution containing about 100 g/l of citric acid, about 100g/l of sodium citrate, about 20 g/l of nickel sulfamate and about 5 g/l of potassium gold cyanide and maintained at 40°C.

The amount deposited of gold, silver, palladium or an alloy thereof is important in the present invention. Namely, the amount deposited is so small that a color tone intermediate between the color tone before plating and the color tone of gold, silver, palladium or an alloy thereof is produced on the plated surface. Supposing that a uniform film of the metal or alloy is formed by plating, the amount deposited is controlled so that the thickness of the gold or palladium film is 30 to 500Å, preferably 50 to 300Å and the thickness of the silver film is 50 to 2,000Å, preferably 100 to 1,000Å (actually, no uniform film is formed but the metal or alloy is deposited in the form of spots).

The passive film on the surface of stainless steel is completely removed by the above-mentioned activating treatment, and hence, the activity of the chromium atom present on the surface is increased, and nickel and gold or the like are selectively plated on the chromium surface having this increased activity and a state where the chromium atom is covered with nickel and gold or the like is produced. Accordingly, the activation of chromium is controlled and is inhibited from reacting with iron. Therefore, a passive coating inherent to stainless steel is not formed again. This phenomenon has been proved by the following experiment.

A stainless steel hoop of SUS-430 (18% Cr, 80% Fe and other elements) was thinly plated with nickel and then gold according to the process of the present invention, and the plated hoop was set at a salt spray tester and the corrosion test was carried out according to the method of JIS Z-2371. Red rusting started within 6 hours, and after passage of 12 hours, the entire surface was covered with red rust.

This rusting rate is the same as the rate of initial rusting of iron. Accordingly, it has been confirmed that the alloying effect of stainless steel by chromium contained in SUS-430, that is, the function of forming a passive coating, was lost, and since nickel and gold were selectively deposited on the surface of chromium in the alloy, only iron was exposed to the salt-spraying atmosphere.

In contrast, in case of non-plated SUS-430, rusting was not caused sven if the salt spray test was conducted for 240 hours, because a touch passive coating was present on the surface.

As is apparent from the foregoing phenomenon, if gold or other noble metal is plated on stainless steel in a very minute amount according to the present invention, the metal is selectively deposited on the surface of chromium to control activation of chromium and prevent reformation of a passive coating. Accordingly, if this surface is soldered, tight soldering can easily be attained on nickel and gold or the like present on chromium in the form of a net or spots and on iron or an Fe-Ni alloy free of a passive coating.

In order to confirm that a passive coating inhibiting soldering is not formed again in a stainless steel article obtained according to the present invention, the test was carried out according to the nitric acid dipping method customarily adopted in the field of stainless steel products for formation of passive coatings. Namely, according to this method, formation of a passive coating is expedited so as to prevent rusting when a fresh surface of stainless steel is exposed by machining or the like.

More specifically, a sample of hoop of SUS-304 was dipped in a 15 volume % solution of nitric acid (68%) for 20 minutes, and the sample was washed, dried and subjected to a solderability test not using a flux in a soldering tank. It was found that the treated sample had an excellent solderability comparable to that before the dipping treatment and even according to this forced test method, a passive coating was not formed again and activation of chromium was completely inhibited.

A product obtained by subjecting a material for an electronic part, for example, a stainless steel band punched into a shape of a lead frame for IC, to the above-mentioned plating treatment, can be soldered very easily and tightly. Moreover, this product is advantageous in that the adaptability to the soldering operation is improved and the wire bondability is enhanced. Since a material customarily used for a lead frame for IC, for example, a copper alloy, is very excellent in the heat conductivity, the soldering heat is promptly absorbed and diffused in the interior of the material at the soldering operation and the initial wettability of the solder to the surface of the copper alloy is low. Accordingly, in order to obtain good soldering, it is necessary to wait a considerable time before the temperature of the portion to be soldered is elevated to the same level as the temperature of the solder, and it is impossible to complete the soldering operation in a short time.

In contrast, in case of stainless steel, absorption and diffusion of the heat into the interior are very slow, and the heat of the solder is concentrated on the surface of the portion to be soldered, and the molten solder is not cooled or solidified and soldering is accomplished in a very short time with a good wettability.

In the conventional materials for lead frames for IC, thick plating of gold, silver, tin or tin-antimony or paste baking of gold or silver is applied to the surface so as to provide a surface on which high-speed bonding is possible. In case of the lead frame for IC according to the present invention, at the wire-bonding operation, according to the same principle as the above-mentioned principle of the soldering operation, the heat of a minute amount of the molten top of an ultra-fine gold wire to be bonded is not lost by absorption or diffusion into the base material und solidification of molten gold is prevented, and therefore, bonding is accomplished in a moment.

The present invention will now be described in detail with reference to the following examples that by no means limit the scope of the invention.

Example 1

A lead frame material of stainless steel SUS-304 punched in a lead frame shape having a thickness of 0.25 mm a width of 25.14 mm and a length of 800 m was passed through the following step (1) through (5) and was subjected to nickel plating and ultra-thin gold plating.

(1) Alkali degreasing step

A commercially available alkali degreasing solution was heated at 70 to 80°C in a stainless steel tank, and the stainless steel lead frame material was passed through this tank in succession to effect primary degreasing. Then, in an aqueous alkali solution maintained at 40 to 60°C, direct current electrolytic degreasing was carried out by using a stainless steel plate as the anode and the stainless steel lead frame material as the cathode and applying a voltage of 6 volts.

(2) First activating step

Then, the stainless steel lead frame material was passed through a bath formed by adding 0.2% by weight of a polyethylene glycol alkyl ether (a nonionic surface active agent) 3% by weight of N-ethyl-2-pyrrolidone and 0.1% by weight of an amine type anti-corrosive agent to a mixed acid comprising 20% by volume of hydrochloric acid (35% solution), 10% by volume of sulfuric acid (85% solution), 10% by weight of citric acid (powder), 1% by volume of acetic acid (90% solution) and 5% by volume of nitric acid (68% solution) to remove oxides and impurities on the surface of the stainless steel lead frame material.

(3) Electrolytic activating step

A bath formed by adding 0.2% by weight of the same nonionic surface active agent as mentioned above, 5% by weight of N-ethyl-2-pyrrolidone and 0.1% by weight of the same anti-corrosive agent to a mixed acid comprising 10% by volume of phosphoric acid (85% solution), 10% by volume of sulfuric acid (85% solution), 5% by volume of citric acid (powder), 8% by volume of nitric acid (68% solution) and 1% by volume of acetic acid (90% solution) was heated at 60°C, and while using the stainless steel lead frame material as the cathode and a platinum-deposited titanium plate as the anode, and applying a voltage of 4 volts, the stainless steel lead frame material was passed through the bath to activate the surface of the stainless steel lead frame material.

(4) Nickel plating step

The temperature of a plating solution comprising 300 g/l of nickel sulfamate, 40 g/l of nickel chloride and 30 g/l of boric acid was maintained at 50°C, and electroplating was carried out for 15 seconds at a current density of 6 A/dm$^2$ by using the stainless steel lead frame material as the cathode and a nickel plate as the above.

As the result, a nickel plating player having a thickness of about 500Å was formed on both the sides of the stainless steel hoop. Incidentally, this thickness of 500Å of the nickel plating layer was not a measured value but a mean value obtained by dividing the amount of the nickel deposited by the area. When the plated surface was examined with the naked eye, it was found that a color tone intermediate between the color tone of the stainless steel and the color tone of nickel was produced on the surface.

(5) Gold plating step

The temperature of a plating solution comprising 120 g/l of citric acid, 120 g/l of sodium citrate, 30 g/l of nickel sulfamate and 8 g/l of gold potassium cyanide was maintained at 45°C, and gold plating was carried out for 2 seconds at a current density of 3 to 10 A/dm$^2$ by using the stainless steel lead frame material as the cathode and a platinum-deposited titanium plate as the anode.

As the result, a gold plating layer having a thickness of 70Å was formed on both the sides of the stainless steel lead frame material, whereby a stainless steel lead frame material of the present invention was obtained. Incidentally, the thickness of 70Å of the gold plating layer was not a measured value but a means value obtained by dividing the amount of the gold deposited by the area. When the surface was examined with the naked eye. It was found that a color tone intermediate between the color tone of the nickel-plated stainless steel and the color tone of gold was produced on the surface.

Example 2

A lead frame material of stainless steel SUS-316 punched into a shape having a thickness of 0.2 mm, a width of 23 mm and a length of 800 m was passed through the following steps (1) through (5) and was continuously subjected to nickel electroplating and immediately to ultra-thin gold electroplating.

The alkali degreasing step (1), first activating step (2), electrolytic activating step (3) and nickel plating step (4) were carried out in the same manner as described in Example 1.

#### (5) Silver plating step

The temperature of a plating solution comprising 30 g/l of silver potassium cyanide and 100 g/l of potassium cycanide was maintained at room temperature, and electroplating was carried out for 10 seconds at a current density of 0.5 A/dm² by using the stainless steel lead frame as the cathode and a silver plate as the anode.

#### Example 3

A lead frame material of stainless steel SUS-304 having a thickness of 0.25 mm, a width of 26 mm and a length of 700 m was passed through the following steps (1) through (5) and was subjected to nickel electroplating and immediately to ultra-thin palladium plating.

The alkali degreasing step (1), first activating step (2), electrolytic activating step (3) and nickel plating step (4) were carried out in the same manner as described in Example 1.

#### (5) Palladium plating step

The temperature of a neutral plating solution containing the palladium component in an amount of 15 g/l as the metal was maintained at 45°C, and plating was carried out at a current density of 5 A/dm² for 3 seconds by using a platinum-deposited titanium plate as the anode and the stainless steel lead frame as the cathode.

As the result a palladium plating layer having a thickness of 70Å was formed on the surface of the stainless steel lead frame material, whereby a lead frame of the present invention was obtained. The thickness of 70Å of the palladium plating layer was not a measured value but a means value obtained by dividing the amount deposited of palladium by the area. When the plated surface was examined with the naked eye, it was found that a color tone intermediate between the color tone of the nickel-plated stainless steel and the color tone of palladium was produced on the surface.

#### Example 4

A lead frame material of stainless steel SUS-304 having a thickness of 0.25 mm, a width of 21 mm and a length of 800 m was passed through the following steps (1) through (5) and was subjected to nickel plating and immediately to ultra-thin palladium-nickel alloy plating.

The alkali degreasing step (1), first activating step (2), electrolytic activating step (3) and nickel plating step (4) were carried out in the same manner as described in Example 1.

#### (5) Palladium-nickel plating step

In a neutral solution containing 8% by weight of sulfamic acid, 20 g/l as the metal of the palladium component and 10 g/l as the metal of the nickel component, Pd-Ni alloy plating was carried out at a current density of 8 to 6 A/dm² at a plating solution temperature of 40°C for 2 seconds by using the stainless steel lead frame material as the cathode and a platinum-deposited titanium plate as the anode.

As the result, a Pd-Ni alloy plating layer having a thickness of about 100Å was formed on the surface of the stainless steel, whereby a stainless steel lead frame material of the present invention was obtained. The thickness of 100Å of the plating layer was not a measured value but a mean value obtained by dividing the amount deposited of the Pd-Ni alloy by the area. When the plated surface was examined with the naked eye, it was found that a color tone intermediate between the color tone of the nickel-plated stainless steel and the color tone of the Pd-Ni alloy was produced on the surface.

The physical and chemical properties of the stainless steel lead frames fr IC prepared in Examples 1 through 4 were tested according to the following procedures.

#### (1) Physical properties
##### (i) Cross-cut peeling test

Square cuts having a size of 1 mm×1 mm were formed by a cutter on the lead frame material of SUS-304 plated with nickel and then gold, palladium or silver according to the present invention, and an adhesive tape was applied to the cut surface and the peeling test was carried out. Peeling of gold, palladium or silver, and nickel was not observed.

##### (ii) Bending test

The above-mentioned sample was bent by 180° and the peeling test was carried out by using an adhesive tape. Peeling of gold, palladium or silver, and nickel was not observed. This bending test was repeated to break the sample. Peeling of Au, Pd or Ag and Ni was not observed on the broken face.

#### (2) Chemical properties
##### (i) High-temperatre high-humidity test

The lead frame material of SUS-316-L ultra-thinly plated with nickel and thin gold, palladium or silver according to the present invention was placed for 7 days in an atmosphere maintained at a relative humidity of 98% and a temperature of 65°C according to the standards of MIL-STD-202D-106C. Then, the solderability and wire bondability were tested. It was found that the solderability of the wire bondability was not degraded at all, and good results were obtained.

##### (ii) Thermal shock test

The lead frame material of SUS-304 ultra-thinly plated with nickel and then gold, palladium or silver according to the present invention was subjected 5 times repeatedly to the heat treatment cycle of +85°C for 30 minutes and −15°C for 30 minutes, and the solderability and wire bondability were tested. The solderability and wire bondability after the heat treatment were the same as those before the heat treatment.

The solderability of each of the above-mentioned stainless steel lead frames were tested according to the following procedures.

(1) Soldering test

The lead frame of SUS-304 ultra-thinly plated with nickel and then gold, palladium or silver was set at a tester, and wetting with solder was electrically detected. The repulsion phenomenon by the surface tension of the solder at the initial stage of dipping was greatly controlled and very good wetting was found. The solderability was higher than the solderability to phosphor bronze tested under the same conditions.

(2) Test in soldering tank

Solder comprising tin and lead at a ratio of 6/4 was fused in a soldering tank and the temperature of the melt was maintained at 230°C. Each of the lead frame materials of SUS-304, SUS-316 and SUS-631 ultra-thinly plated with nickel and then gold, siver or palladium, which had been subjected to surface washing with trichloroethane, was soldered in the flux-free state for a dipping time of 3 or 5 seconds. In each case, a good solderability was observed and a solider deposition higher than 95% was obtained.

(3) Test using electric soldering iron

Each of three lead frame materials of SUS-304 thinly plated with nickel and then gold, silver or palladium according to the present invention was soldered to a 0.02 mm-diameter wire of SUS-316-L ultra-thinly plated with nickel and then gold by using a commercially available electric soldering iron and a linear resin-incorporated solder (tin/lead=6/4). Excellent solderability and bondability were observed. Thus, it was confirmed that soldering of stainless steels differing in the composition could be accomplished advantageously.

(4) Tensile strength test

Two lead frame materials of SUS-304 ultra-thinly plated with nickel and then gold were soldered together with a solder comprising tin and lead at a ratio of 6/4. The tensile strength at +20°C was 3 to 4.1 kg/cm² while the tensile strength of soldered iron at +20°C was 3.2 to 4.5 kg/cm², but the tensile strength at +100°C was 1.4 to 2.6 kg/cm², which was higher than the tensile strength of soldered iron at +100°C, that was 1.3 to 2.4 kg/cm².

The bonding strength of a gold wire bonded to the above lead frame material was 7 g on the average. It was confirmed that the above lead frame material could be advantageously used for a lead frame for IC.

Example 5

A stainless steel hoop of SUS-304 having a thickness of 0.2 mm, a width of 40 mm and a length of 800 m was thinly plated with nickel and immediately ultra-thinly plated with gold through the same alkali degreasing step (1), first activating step (2), electrolytic activating step (3), nickel plating step (4) and gold plating step (5) as described in Example 1.

A nickel plating layer having a thickness of about 500Å was formed on both the sides of the stainless steel hoop at the nickel plating step. When the plated surface was examined with the naked eye, it was found that a color tone intermediate between the color tone of the stainless steel and the color tone of nickel was produced on the surface.

A gold plating layer having a thickness of 100Å was formed on both the side of the stainless steel hoop at the gold plating step. When the plated surface was examined with the naked eye, it was found that a color tone intermediate between the color tone of the nickel-plated stainless steel and the color tone of gold was produced on the surface.

Example 6

A bobbin-wound stainless steel wire of SUS-304 having a wire diameter of 0.1 mm was continuously thinly plated with nickel and then gold through the same steps (1) through (5) as described in Example 5.

Example 7

A stainless steel hoop of SUS-631 having a thickness of 0.1 mm, a width of 20 mm and a length of 700 m was thinly plated with nickel and immediately ultra-thinly plated with gold through the following steps (1) through (5).

The alkali degreasing step (1), first activating step (2), electrolytic activating step (3) and Ni plating step (4) were carried out in the same manner as described in Example 1.

(5) Ultra-thin gold plating

The temperature of a plating solution comprising 30 g/l of silver gold cyanide and 100 g/l of potassium cycanide was maintained at room temperature, and plating was continuously carried out for 10 seconds at a current density of 0.5 A/dm² by using a copper plate as the anode and the stainless steel hoop as the cathode.

Example 8

A stainless steel hoop of SUS-304 having a thickness of 0.25 mm, a width of 30 mm and a length of 700 m was thinly plated with Ni and immediately ultra-thinly plated with Pd through the following steps (1) through (5).

The alkali degreasing step (1) first activating step (2), electrolytic activating step (3) and nickel plating step (4) were carried out in the same manner as described in Example 5.

(5) Palladium plating step

The temperature of a neutral plating solution containing 15 g/l as the metal of the palladium component and plating was carried out a current density of 5 A/dm² for 3 seconds by using a platinum-deposited titanium plate as the anode and the stainless steel hoop as the cathode.

As the result, a palladium plating layer having a thickness of 70Å was formed on the surface of the stainless steel hoop, whereby a stainless steel hoop according to the present invention was obtained. The thickness of 70 of the palladium plating layer was not a measured value but a mean value obtained by dividing the amount deposited of Pd of the area. When the plated surface was examined with the naked eye, it was found that a color tone intermediate between the color tone of the nickel-plated stainless steel and the color tone of palladium was produced on the surface.

Example 9

A stainless steel wire of SUS-304 having a wire diameter of 1.0 mm was thinly plated with nickel and then ultra-thinly plated with a palladium-nickel alloy through the following steps.

The alkali degreasing step (1), first activating step (2), electrolytic activating step (3) and nickel plating step (4) were carried out in the same manner as described in Example 5.

(5) Palladium-nickel alloy plating step

In a neutral solution containing 8% by weight of sulfamic acid, 20 g/l as the metal of the palladium component and 10 g/l as the metal of the nickel component, palladium-nickel alloy plating was carried out for 3 seconds at a current density of 8 to 6 A/dm² at a solution temperature of 30°C by using the stainless steel wire as the cathode and a platinum-deposited titanium plate as the anode.

As the result, a palladium-nickel alloy plating layer having a thickness of about 100Å was formed on the surface of the stainless steel, whereby a stainless steel wire according to the present invention was obtained. The thicknesss of 100Å of the plating layer was not a measured value but a mean value obtained by dividing the amount deposited of the palladium-nickel alloy by the area. When the plated surface was examined with the naked eye, it was found that a color tone intermediate between the color tone of the nickel-plated stainless steel and the color tone of the palladium-nickel alloy was produced on the surface.

The physical and chemical properties of the stainless steel hoops obtained in Examples 5 through 9 were tested according to the same test methods as adopted for testing the lead frames obtained in Examples 1 through 4.

The results obtained at the square-cut peeling test, bending test, high-temperature high-humidity test, thermal shock test, soldering test, soldering tank test, electric soldering iron test and tensile strength test were substantially the same as those obtained with respect to the lead frames of Examples 1 through 4.

Stainless steel hoops were thinly plated with Ni and then ultra-finely plated with Au, Ag, Pd, Pd-Ni, Au-Ag, Au-Pd and Au-Cu, respectively. The plated hoops were allowed to stand still for 2 weeks, and the hoops of the same kind or the hoops of two or more kinds were soldered together. It was found that Au was highest in the solderability and the solderability was gradually reduced in the order of Ag, Au-Ag, Au-Cu, Au-Pdm Pd and Pd-Ni.

The stainless steel article of the present invention retains an especially high corrosion resistance of stainless steel and is excellent over a copper alloy in the spring property, creep characteristics and strength, and the price of this stainless steel article is very low. Namely, the fatal defect of stainless steel, that is, poor solderability, is overcome according to the present invention and good solderability can be imparted to stainless steel, and industrial application fields of stainless steel will be broadened. More specifically, the stainless steel article can be used for parts to be soldered, for example, a connector, a socket, a switch, a terminal, a battery holder, a spring, a facsimile fine wire and the like. Moreover, the stainless steel lead frame for IC according to the present invention is excellent in the solderability and wire bondability and is excellent over the conventional lead frame materials in the corrosion resistance and creep characteristics. Therefore, the stainless steel article of the present invention can be advantageously used widely in various fields, for example, for ordinary lead frames for IC, vehicle-loaded electronic devices used under severe conditions, machines, air planes and weapons.

**Claims**

1. A stainless steel article having a solderability, which comprises a thin plating layer of nickel formed on the surface of stainless steel, and an ultra-thin plating layer of a metal selection from the group consisting of gold, silver and palladium, or an alloy selected from the group consisting of gold-, silver- or palladium-containing alloys, which is formed on the nickel plating layer, the amount of the nickel deposited being so small that a color tone intermediate between the color tone of stainless steel and the color tone of nickel is produced when plated with nickel and the amount of the gold, silver or palladium or the alloy thereof deposited being so small that a color tone intermediate between the color tone of the nickel-plated stainless steel and the color tone of gold, silver or palladium or the alloy thereof, when plated with gold, silver or palladium or the alloy thereof is produced.

2. A stainless steel article according to claim 1, wherein the amount of the deposited nickel is 500Å as expressed in terms of thickness which is calculated by dividing the amount of the deposited nickel by the area.

3. A stainless steel article according to claim 1, wherein the amount of the deposited nickel is in the range of 300 to 700Å as expressed in terms of thickness which is calculated by dividing the amount of the deposited nickel by the area.

4. A stainless steel article according to claim 1, wherein the amount of the deposited gold, palladium or alloy thereof is in the range of 30 to 500Å as expressed in terms of thickness which is calculated by dividing the amount of the deposited gold, palladium or alloy thereof by the area.

5. A stainless steel article according to claim 1, wherein the amount of the deposited gold, palladium or alloy thereof is in the range of 50 to 300Å as expressed in terms of thickness which is calculated by dividing the amount of the deposited gold, palladium or alloy thereof by the area.

6. A stainless steel article according to claim 1, wherein the amount of the deposited silver or alloy thereof deposited is in the range of 50 to 2,000Å as expressed in terms of thickness which is calculated by dividing the amount of the deposited silver or alloy thereof by the area.

7. A stainless steel article according to claim 1, wherein the amount of the deposited silver or alloy thereof is in the range of 100 to 1,000Å as expressed in terms of thickness which is calculated by dividing the amount of the deposited silver or alloy thereof by the area.

8. A stainless steel article according to claim 1, which is a lead frame for IC.

9. A method of making a stainless steel article having a solderabiltity, which comprises:

electroplating a stainless steel material with nickel to an extent such that the resulting nickel-plated stainless steel material exhibits a color tone intermediate between the color tone of stainless steel and the color tone of nickel, and immediately thereafter, electroplating the nickel-plated stainless steel material with a metal selected from the group consisting of gold, silver and palladium, and alloys of these metals, to an extent such that the resulting plated stainless steel material exhibits a color tone intermediate between the color tone of the nickel-plated stainless steel material and the color tone of the gold, silver, palladium or alloy thereof used.

10. A method according to claim 9, wherein the amount of the deposited nickel is 500Å as expressed in terms of thickness which is calculated by dividing the amount of the deposited nickel by the area.

11. A method according to claim 9, wherein the amount of the deposited nickel is in the range of 300 to 700Å as expressed in terms of thickness which is calculated by dividing the amount of the deposited nickel by the area.

12. A method a according to claim 9, wherein the electroplating with nickel is carried out at a temperature of 45 to 65C at a cathode current density of 4 to 12 ampere/dm² for a period of 10 seconds to 2 minutes.

13. A method according to claim 9, wherein the amount of the deposited gold, palladium or alloy thereof in in the range of 30 to 500Å as expressed in terms of thickness which is calculated by dividing the amount of the deposited gold, palladium or alloy thereof by the area.

14. A method according to claim 9, wherein the amount of the deposited gold, palladium or alloy thereof is in the range of 50 to 300Å as expressed in terms of thickness which is calculated by dividing the amount of the deposited gold, palladium or alloy thereof by the area.

15. A method according to claim 9, wherein the amount of the deposited silver or alloy thereof deposited is in the range of 50 to 2,000Å as expressed in terms of thickness which is calculated by dividing the amount of the deposited silver or alloy thereof by the area.

16. A method according to claim 9, wherein the amount of the deposited silver or alloy thereof is in the range of 100 to 1,000Å as expressed in terms of thickness which is calculated by dividing the amount of the deposited silver or alloy thereof by the area.

17. A method according to claim 9, wherein the electroplating with gold, silver, palladium or an alloy thereof is carried out at a temperature of 40 to 65°C at a cathode current density of 0.5 to 18 ampere/dm² for a period of 1 second to 2 minutes.

18. A method according to claim 9, wherein, prior to the electroplating with nickel, the stainless steel material is dipped in an activating solution containing, based on the weight of the solution:

(i) 3 to 20% by weight of hydrochloric acid,
(ii) 2 to 30% by weight of sulfuric acid,
(iii) 0.1 to 5% by weight of a nonionic or cationic surface active agent and
(iv) 0.1 to 20% by weight of 2-pyrrolidone or its N-alkyl derivative, and then, the activated stainless steel material is subjected to cathodic electrolysis in a cathode electrolytic activation solution containing, based on the weight of the solution:

(i) 5 to 20% by weight of phosphoric acid,
(ii) 2 to 10% by weight of nitric acid,
(iii) 0.1 to 5% by weight of a nonionic surface active agent and
(iv) 0.1 to 20% weight of 2-pyrrolidone or its N-alkyl derivative.

19. A method according to claim 9, wherein the stainless steel articles is a lead frame for IC.

**Patentansprüche**

1. Edelstahlgegenstand, der gelötet werden kann und eine dünne Nickelplattierungsschicht, die auf der Oberfläche des Edelstahls gebildet ist, und eine ultradünne Plattierungsschicht aus einem Metall, das aus der Gruppe gewählt wurde, die aus Gold, Silber und Palladium besteht, oder aus einer Legierung aufweist, die aus der Gruppe ausgewählt wurde, die aus gold-, silber- und palladiumhaltigen Legierungen besteht, wobei diese Schicht auf der Nickelplattierungsschicht gebildet ist, die niedergeschlagene Nickelmenge so gering ist, daß ein Farbton zwischen dem Frabton des Edelstahls und dem Farbton des Nickels nach der Plattierung mit Nickel hergestellt ist, und die darauf niedergeschlagene Menge an Gold, Silber oder Palladium oder an der Legierung davon so gering ist, daß ein Farbton zwischen dem Farbton des mit Nickel plattierten Edelstahls und dem Farbton von Gold, Silber oder Palladium oder der Legierung davon nach dem Plattieren mit Gold, Silber oder Palladium oder mit der Legierung davon hergestellt ist.

2. Edelstahlgegenstand nach Anspruch 1, bei dem die Menge an niedergeschlagenem Nickel 500Å ausmacht, ausgedrückt als Dicke, die dadurch errechnet wird, daß die Menge des niedergeschlagenen Nickels durch die Fläche dividiert wird.

3. Edelstahlgegenstand nach Anspruch 1, bei dem die Menge des niedergeschlagenen Nickels in einem Bereich von 300—700Å liegt, ausgedrückt als Dicke, die dadurch errechnet wird, daß die Menge des niedergeschlagenen Nickels durch die Fläche dividiert wird.

4. Edelstahlgegenstand nach Anspruch 1, bei dem die Menge des niedergeschlagenen Golds, Palladiums oder der Legierung davon in einem Bereich von 30—500Å liegt, ausgedrückt als Dicke, die dadurch errechnet wird, daß die Menge des niedergeschalgenen Gold, Palladium oder der Legierung durch die Fläche dividiert wird.

5. Edelstahlgegenstand nach Anspruch 1, dadurch gekennzeichnet, daß die Menge des niedergeschlagenen Gold, Palladium oder der Legierung davon Bereich von 50—300Å liegt, ausgedrückt als Dicke, die dadurch errechnet wird, daß die Menge des niedergeschlagenen Gold, Palladium oder der Legierung durch die Fläche dividiert wird.

6. Edelstahlgegenstand nach Anspruch 1, dadurch gekennzeichnet, daß die Menge des niedergeschlagenen Silbers oder der Legierung davon in einem Bereich von 50—2000Å liegt, ausgedrückt als Dicke, die dadurch berechnet wird, daß die Menge des niedergeschlagenen Silbers oder der Legierung durch die Fläche dividiert wird.

7. Edelstahlgegenstand nach Anspruch 1, bei dem die Menge des niedergeschlagenen Silbers oder der Legierung davon in dem Bereich von 100—1000Å liegt, ausgedrückt als Dicke, die dadurch berechnet wird, daß die Menge des niedergeschlagenen Silbers oder der Legierung durch die Fläche dividiert wird.

8. Edelstahlgegenstand nach Anspruch 1, der ein Leiterrahmen für ein IC ist.

9. Verfahren zur Herstellung eines Gegenstands aus Edelstahl, der lötbar ist, bei dem ein Edelstahlmaterial mit Nickel in einem solchen Maß elektroplattiert wird, daß das erhaltene nickelplattierte Edelstahlmaterial einen Farbton aufweist, der zwischen dem Farbton des Edelstahls und dem Farbton des Nickels liegt, und

unmittelbar danach das nickelplattierte Edelstahlmaterial mit einem Metall, das aus der Gruppe gewählt wurde, die aus Gold, Silber und Palladium besteht, und Legierungen dieser Metalle in einem solchen Plattierte Edelstahlmaterial einen Farbton aufweist, der zwischen dem Farbton des nickelplattierten Edelstahlmaterials und dem Farbton des verwendeten Golds, Silbers oder Palladiums oder deren Legierung liegt.

10. Verfahren nach Anspruch 9, bei dem die Menge des niedergeschlagenen Nickels 500Å ist, ausgedrückt als Dicke, die dadurch errechnet wird, daß die Menge des niedergeschlagenen Nickels durch die Fläche dividiert wird.

11. Verfahren nach Anspruch 9, bei dem die Menge des niedergeschlagenen Nickels in dem Bereich von 300—700Å liegt, ausgedrückt als Dicke, die dadurch berechnet wird, daß Menge des niedergeschlagenen Nickels durch die Fläche dividiert wird.

12. Verfahren nach Anspruch 9, bei dem die Elektroplattierung mit Nickel bei einer Temperatur von 45—65°C und bei einer Kathodenstromdichte von 4—12 A/dm² während einer Zeitdauer von 10 sek bis 2 min durchgeführt wird.

13. Verfahren nach Anspruch 9, bei dem die Menge des niedergeschlagenen Golds, Palladiums oder deren Legierung in dem Bereich von 30—500Å liegt, ausgedrückt als Dicke, die dadurch errechnet wird, daß die Menge des niedergeschlagenen Golds, Palladiums oder deren Legierung durch die Fläche dividiert wird.

14. Verfahren nach Anspruch 9, bei dem die Menge des niedergeschlagenen Golds, Palladiums oder deren Legierung in dem Bereich von 50—300Å liegt, ausgedrückt als Dicke, die dadurch errechnet wird, daß die Menge des niedergeschlagenen Golds, Palladiums oder deren Legierung durch die Fläche dividiert wird.

15. Verfahren nach Anspruch 9, bei dem die Menge des niedergeschlagenen Silbers oder deren niedergeschlagene Legierung in dem Bereich von 50—2000Å liegt, ausgedrückt als Dicke, die dadurch berechnet wird, daß die Menge des niedergeschlagenen Silbers oder ihrer Legierung durch die Fläche dividiert wird.

16. Verfahren nach Anspruch 9, bei dem die Menge des niedergeschlagenen Silbers oder ihrer Legierung in dem Bereich von 100—1000Å liegt, ausgedrückt als Dicke, die dadurch errechnet wird, daß die Menge des niedergeschlagenen Silbers oder ihrer Legierung durch die Fläche dividiert wird.

17. Verfahren nach Anspruch 9, bei dem die Elektroplattierung mit Gold, Silber, Palladium oder einer Legierung hiervon bei einer Temperatur von 40—65°C und einer Kathodenstromdichte von 0,5—18 A/dm² für eine Zeitdauer von 1 sek bis 2 min durchgeführt wird.

18. Verfahren nach Anspruch 9, bei dem vor dem Elektroplattieren mit Nickel das Edelstahlmaterial in eine aktivierende Lösung eingetaucht wird, die bezogen auf das Gewicht der Lösung

(i) 3 bis 20 Gew.-% Salzsäure,

(ii) 2 bis 30 Gew.-% Schwefelsäure,

(iii) 0,1 bis 5 Gew.-% eines nichtionischen oder kationischen oberflächenaktiven Mittels und

(iv) 0,1 bis 20 Gew.-% 2-Pyrrolidon oder ein N-Alkylderivate davon enthält,

und anschließend das aktivierte Edelstahlmaterial einer kathodischen Elektrolyse in einer Aktivierungslösung für die kathodische Elektrolyse unterzogen wird, die bezogen auf das Gewicht der Lösung

   (i) 5 bis 20 Gew.-% Phosphorsäure,

   (ii) 2 bis 10 Gew.-% Salpetersäure,

   (iii) 0,1 bis 5 Gew.-% eines nichtionischen oberflächenaktiven Mittels und

   (iv) 0,1 bis 20 Gew.-% 2-Pyrrolidon oder ein N-Alkylderivat davon enthält.

19. Verfahren nach Anspruch 9, bei dem der Edelstahlgegenstand ein Leiterrahmen für ein IC ist.

## Revendications

1. Objet d'acier inoxydale ayant une certaine soudabilité, comprenant une mince couche de revêtement de nickel formée à la surface de l'acier inoxydable, et une couche de revêtement ultramince d'un métal choisi dans le groupe constitué par l'or, l'argent et le palladium, on d'un alliage choisi dans le groupe constitué par les alliages contenant de l'or, de l'argent ou du palladium, qui est formée sur la couche de revêtement de nickel, la quantité de nickel déposée étant si faible qu'on produit une nuance de couleur intermédiaire entre la nuance de couleur de l'acier inoxydable et la nuance de couleur du nickel lorsqu'on dépose du nickel, et la quantité d'or, d'argent ou de palladium ou de leurs alliages déposée étant si faible qu'on produit une nuance de couleur intermédiaire entre la nuance de couleur de l'acier inoxydable revête de nickel et la nuance de couleur de l'or, de l'argent ou du palladium on leurs alliages, lorsqu'on dépose de l'or, de l'argent ou du palladium ou leurs alliages.

2. Objet d'acier inoxydable selon la revendication 1, dans lequel la quantité de nickel déposée est de 500Å exprimée en termes d'épaisseur qui est calculée en divisant la quantité de nickel déposée par la surface.

3. Objet d'acier inoxydable selon la revendication 1, dans lequel la quantité de nickel déposée est dans l'intervalle allant de 300 à 700Å exprimée en termes d'épaisseur qui est calculée en divisant la quantité de nickel déposée par la surface.

4. Objet d'acier inoxydable selon la revendication 1, dans lequel la quantité déposée d'or, de palladium ou de leurs alliages est dans l'intervalle allant de 30 à 500Å exprimée en termes d'épaisseur qui est calculée en divisant la quantité déposée d'or, de palladium ou de leurs alliages par la surface.

5. Objet d'acier inoxydable selon la revendication 1, dans lequel la quantité déposée d'or, de palladium ou de leurs alliages est dans l'intervalle allant de 50 à 300 exprimée en termes d'épaisseur qui est calculée en divisant la quantité déposée d'or, de palladium ou de leurs alliages par la surface.

6. Objet d'acier inoxydable selon la revendication 1, dans lequel la quantité déposée d'argent ou de ses alliages est dans l'intervalle de 50 à 2000Å exprimée en termes d'épaisseur qui est calculée en divisant la quantité déposée d'argent ou de ses alliages par la surface.

7. Objet d'acier inoxydable selon la revendication 1, dans lequel la quantité déposée, d'argent ou de ses alliages est dans l'intervalle allant de 100 à 1000Å exprimée en termes d'épaisseur qui est calculée en divisant la quantité déposée d'argent ou des ses alliages par la surface.

8. Objet d'acier inoxydable selon la revendication 1, qui est un support de connexion pour circuit intégré (CI).

9. Procédé de préparation d'un objet d'acier inoxydable ayant une certain soudabilité, dans lequel:

on effectue un dépôt électrolytique de nickel sur une matière inoxydable dans une mesure telle que la matière d'acier inoxydable revêtue de nickel résultante présente une nuance de couleur intermédiaire entre la nuance de couleur de l'acier ionxydable et la nuance de couleur du nickel, et

immédiatement ensuite, on effectue un dépôt électrolytique sur de la matière d'acier inoxydable revêtue de nickel avec un métal choisi dans le groupe constitué par l'or, l'argent et le palladium, et les alliages de ces métaux, dans une mesure telle que la matière d'acier inoxydable revêtue résultante présente une nuance de couleur intermédiaire entre la nuance de couleur de la matière d'acier inoxydable revête de nickel et la nuance de couleur de l'or, de l'argent, du palladium ou de leurs alliages utilisés.

10. Procédé selon la revendication 9, dans lequel la quantité de nickel déposée est 500Å exprimée en termes d'épaisseur qui est calculée en divisant la quantité de nickel déposée par la surface.

11. Procédé selon la revendication 9, dans lequel la quantité de nickel déposée est dans un intervalle allant de 300 à 700Å exprimée en termes d'épaisseur que est calculée en divisant la quantité de nickel déposée par la surface.

12. Procédé selon la revendication 9, dans lequel on effectue dépôt galanoélectrolytique de nickel à une température de 45 à 65°C à une densité de courant à la cathode de 4 à 12 ampère/dm² pendant une période de 10 seconds à 2 minutes.

13. Procédé selon la revendication 9, dans lequel la quantité déposée d'or, de palladium ou de leurs alliages est dans l'intervalle allant de 30 à 500Å exprimée en termes d'épaisseur qui est calculée en divisant la quantité déposée d'or, de palladium ou de leurs alliages par la surface.

14. Procédé selon la revendication 9, dans lequel la quantité déposée d'or, de palladium ou de leurs alliages est dans l'intervalle allant de 50 à 300Å exprimée en termes d'épaisseur qui est calculée en divisant la quantité d'or, de palladium ou de leurs alliages par la surface.

15. Procédé selon la revendication 9, dans lequel la quantité déposée d'argent ou de ses alliages est dans l'intervalle allant de 50 à 2000Å exprimée en termes d'épaisseur qui est calculée en divisant la quantité déposée d'argent ou de ses alliages par la surface.

16. Procédé selon la revendication 9, dans lequel la quantité déposé d'argent ou de ses alliages est dans l'intervalle de 100 à 1000Å exprimée en termes d'épaisseur qui est calculée en divisant la quantité déposée d'argent ou de ses alliages par la surface.

17. Procédé selon la revendication 9, dans lequel on conduit la galvanoplastie avec l'or, l'argent, le palladium ou un de leurs alliages à une température de 40 à 65°C à une densité de courant à la cathode de 0,5 à 18 ampère/dm$^2$ pendant une période de 1 seconde à 2 mintues.

18. Procédé selon la revendication 9, dans lequel, avant le dépôt électrolytique de nickel, on plonge la matière d'acier inoxydable dans une solution activante contenant, sur la base du poids de la solution:

(i) 3 à 20% en poids d'acide chlorhydrique,

(ii) 2 à 30% en poids d'acide sulfurique,

(iii) 0,1 à 5% en poids d'un agent tensio-actif non ionique ou cationique et

(iv) 0,1 à 20% en poids de 2-pyrrolidone ou de son dérivé N-alcoyle,

puis on soumet la matière d'acier inoxydable activée à une électrolyse cathodique dans une solution d'activation électrolytique à la cathode contenant, sur la base du poids de la solution:

(i) 5 à 20% en poids d'acide phosphorique,

(ii) 2 à 10% en poids d'acide nitrique,

(iii) 0,1 à 5% en poids d'un agent tensio-actif non ionique et

(iv) 0,1 à 20% en poids de 2-pyrrolidone ou de son dérivé N-alcoyle.

19. Procédé selon la revendication 9, dans lequel l'article d'acier inoxydable est un support de connexion pour circuit intégré.